# EUROPÄISCHE PATENTANMELDUNG

(11) **EP 4 141 610 A1**
(43) Veröffentlichungstag der Anmeldung: **01.03.2023**
(21) Anmeldenummer: 22188591.6
(22) Anmeldetag: 03.08.2022
(51) Int. Cl.: G05G 1/04, G05G 9/047, E02F 9/20, G01K 7/00, H03K 17/96, H05B 3/20

(54) **JOYSTICK MIT MULTIFUNKTIONALEM TRÄGERELEMENT**

(30) Priorität: 30.08.2021 DE 102021122398
(71) Anmelder: elobau GmbH & Co. KG, 88299 Leutkirch im Allgäu (DE)
(72) Erfinder: GERHARDT, Ulrich, 87452 Altusried (DE); CALIEBE, Simon, 88316 Isny (DE); STIEHLE, Robert, 74074 Heilbronn (DE)
(74) Vertreter: VKK Patentanwälte PartG mbB

(57) **Zusammenfassung**

Joystick zur Bedienung von Nutzfahrzeugen, aufweisend einen Griffbereich, wobei der Griffbereich eine stoffschlüssige und/oder formschlüssige Verbindung zu einem Trägerelement aufweist, wobei an dem Trägerelement mindestens drei materialidentische Leiterelemente angeordnet sind, wobei mindestens ein Leiterelement als ein Heizelement, eines als ein Temperatursensorelement und eines als ein berührungserfassendes Element ausgebildet sind.

## Beschreibung

Die vorliegende Erfindung betrifft einen Joystick zur Bedienung von Nutzfahrzeugen, aufweisend einen Griffbereich, wobei der Griffbereich eine stoffschlüssige Verbindung zu einem Trägerelement aufweist, wobei an dem Trägerelement mindestens drei insbesondere materialidentische Leiterelemente angeordnet sind.

Derartige Joysticks dienen in Nutzfahrzeugen, insbesondere in off-road Fahrzeugen, üblicherweise zur Steuerung verschiedenster beweglicher Komponenten des Nutzfahrzeugs. Da diese nicht ausschließlich über geschlossene Fahrerkabinen verfügen, oder Fahrerkabinen bei niedrigen Außentemperaturen nur bedingt zu heizen sind, ist es notwendig, die an dem Joystick anliegende Hand eines Nutzers vor Kälte zu schützen. Dies könnte zwar grundsätzlich durch das Tragen von Handschuhen geschehen, jedoch sind diese unvorteilhaft, da sie eine präzise und justiergenaue Bedienung des Joysticks deutlich erschweren oder sogar unmöglich machen. Zudem können trotz getragener Handschuhe kältebedingte Gesundheitsschäden nicht ausgeschlossen werden, mindestens leidet die Konzentration eines Bedieners aufgrund seiner klammen oder kalten Hände. Es ist daher wünschenswert, die am Joystick anliegende Hand eines Bedieners über am Joystick angeordnete Heizelemente warmzuhalten.

Derartige Joystick-Temperiervorrichtungen sind aus dem Stand der Technik bekannt. Die DE 10 2011 121 979 A1 offenbart eine Temperiereinrichtung, insbesondere für einen Steuergriff innerhalb eines Fahrzeuges, wobei die Temperiereinrichtung Temperierstränge aufweist, die in Fixierungsausnehmungen eines Trägers eingelegt und von einer Deckschicht beabstandet ausgebildet sind. Hierbei überdeckt diese Deckschicht den Träger mindestens teilweise. Zwischen Temperiereinrichtung und Träger besteht eine stoffschlüssige Verbindung, insbesondere durch Kleben. Dieses Dokument beschreibt auch einen Sensor zur Detektion der Temperatur und/oder des Kontakts mit einem Benutzer.

Die US 10,329,736 B2 beschreibt einen Bagger, aufweisend zwei Joysticks mit jeweils einem Griffbereich, wobei der Griffbereich ein Heizelement aufweist, dass seinerseits eine Heizleitung oder ein flexibles Wärmeübertragungssubstrat aufweist. Einer der Joysticks ist mit einem Temperatursensor versehen. Die Heizelemente sind über ein Steuerelement in Abhängigkeit der Daten vom Temperatursensor, einem aktiven Generator, einem Sperrschalter und einem Heizschalter, sowie einer vom Nutzer voreingestellten Temperatureinstellung aktivierbar.

Dieser aus dem Stand der Technik bekannte, sehr komplexe Aufbau von Heizelement, Sensorelementen und Steuerelementen auf einem Joystick bringt eine große Fehleranfälligkeit mit sich, sowohl während des Fertigungsprozesses, als auch während einer Nutzung in einer stark verschmutzten und rauen Umgebung mit großen Temperaturunterschieden. Eine derartige Komplexität erhöht ebenfalls die Herstellungskosten.

Die vorliegende Erfindung stellt sich daher die Aufgabe, einen kostengünstigen und einfach herzustellenden Joystick mit einer hohen Funktionsdichte vorzuschlagen.

Diese Aufgabe wird gelöst durch einen Joystick zur Bedienung von Nutzfahrzeugen, aufweisend einen Griffbereich, wobei der Griffbereich eine stoffschlüssige und/oder formschlüssige Verbindung zu einem Trägerelement aufweist, wobei an dem Trägerelement mindestens drei, vorzugsweise materialidentische, Leiterelemente angeordnet sind, wobei mindestens ein Leiterelement als ein Heizelement, eines als ein Temperatursensorelement und eines als ein berührungserfassendes Element ausgebildet sind. Der Griffbereich weist bevorzugt eine an die Handfläche eines Nutzers angepasste Form auf. Das Trägerelement ist in Form und Materialelastizität vorteilhafterweise so ausgebildet, dass es leicht auf den Griffbereich aufbringbar ist. Die stoffschlüssige Verbindung zwischen Griffbereich und Trägerelement ist bevorzugt durch Kleben, oder ein Heiß-Präge-Verfahren hergestellt, jedoch ist auch eine formschlüssige Verbindung zwischen Griffbereich und Trägerelement erfindungsgemäß, insbesondere eine, die durch ein In-Mold-Verfahren erzeugt ist. Die Leiterelemente sind vorteilhafterweise aus einem elektrisch leitfähigen Werkstoff, insbesondere aus Karbonfasern oder einem metallischen Werkstoff wie Silber, Kupfer, oder Aluminium oder aus einer Legierung aus diesen Werkstoffen gebildet. Die mindestens drei Leiterelemente sind bevorzugt von unterschiedlicher Form, Größe und Anordnung, so dass sie optimal an ihre jeweilige Funktion angepasst sind.

Das als Heizelement ausgebildete Leiterelement ist vorteilhafterweise möglichst gleichmäßig und großflächig über dem Trägerelement angeordnet, um eine gleichmäßige und hohe Wärmeabgabe zu ermöglichen.

Das als Temperatursensorelement ausgebildete Leiterelement ist bevorzugt so am Trägerelement angeordnet, dass es den Punkt oder Bereich mit der höchsten oder der niedrigsten Temperatur erfassen kann. In Ausgestaltung der Erfindung sind zwei oder mehr

Temperatursensorelemente vorgesehen, die am Punkt der höchsten und der niedrigsten Temperatur angeordnet sind, um die höchste Temperaturdifferenz bestimmbar zu machen. Hierdurch ist mit Vorteil eine mittlere Temperatur bestimmbar und damit auch eine Anpassung der Wärmeleistung des Heizelements ermöglicht, die zu einer ausreichenden mittleren Temperatur des Joystickgriffbereichs führt. Bei der Ausführungsform der Erfindung mit nur einem Temperatursensorelement ist mittels Temperaturverlaufskennlinien ein Temperaturabfall beziehungsweise -anstieg über das Trägerelement hinweg bestimmbar, so dass auch bei dieser Ausführungsform die mittlere Temperatur erfassbar und so die Wärmeabgabe des Heizelements anpassbar sind. Das Temperatursensorelement ist bevorzugt als Kaltleiter ausgebildet, bei dem die Änderung des elektrischen Widerstandes in Abhängigkeit von der Temperatur messbar ist. Durch eine erfindungsgemäße Verwendung eines Vier-Leiter-Anschlusses des Temperatursensorelements ist eine getrennte Zuführung des Messstromes ermöglicht, so dass der Einfluss von Übergangs- und Leitungswiderständen kompensierbar ist. Ebenfalls erfindungsgemäß ist die Ausbildung eines Leiterelements, welches die Funktionen eines Heizelements und die eines Temperatursensorelements umfasst.

Die Ausbildung mindestens eines Leiterelements als berührungserfassendes Element ermöglicht mit Vorteil die zuverlässige Erkennung einer am Joystickgriff anliegenden Bedienerhand. Das berührungserfassende Element ist flächig auf das Trägerelement aufgebracht, sodass eine Erkennung auch bei verschiedenen Handstellungen gewährleistet ist. Das berührungserfassende Element ist erfindungsgemäß als kapazitives, induktives, optisches oder resistives Element oder als Temperatursensorelement ausgebildet.

Erfindungsgemäß sind die Leiterelemente mittels eines Druckverfahrens, insbesondere mittels Siebdruckes, auf eine erste Seitenfläche und/oder eine zweite Seitenfläche des Trägerelements aufgedruckt. In vorteilhafter Weise sind mindestens alle funktionsgleichen Leiterelemente auf einer gemeinsamen Seite gedruckt. Erfindungsgemäß ist das Trägerelement während des Siebdruckprozesses in einem Rahmen einer Druckform eingelegt. Anschließend wird eine Schablone auf das Trägerelement aufgebracht, welche die Beschichtung an den nicht vorgesehenen Stellen verhindert. Die Beschichtung ist auf die Schablone und das Trägerelement mittels einer Rakel aufbringbar. Nach dem Druck wird das Trägerelement der Maschine entnommen. Die Beschichtung bildet erfindungsgemäß die Leiterelemente. Je nach Material der Leiterelemente ist eine Versiegelung auf das Trägerelement aufgetragen, um die Leiterelemente vor äußeren Einflüssen und Korrosion zu schützen. Sofern eine Änderung der Leiterelemente an sich oder deren Anordnung auf dem Trägerelement notwendig ist, bedarf es lediglich der Erstellung einer neuen Schablone je Seitenfläche. Der weitere Fertigungsprozess bleibt unberührt, was eine schnelle und einfache Umrüstung und somit eine Kostenersparnis zur Folge hat.

In Weiterbildung der Erfindung ist vorgesehen, dass das Trägerelement als Trägerfolie ausgebildet ist und/oder selbstklebend und/oder hitzebeständig ist. In besonders vorteilhafter Weise ist die Flexibilität der Trägerfolie derart ausgebildet, dass diese im Wesentlichen an die Form des Griffbereichs anpassbar ist. Es ist ebenfalls erfindungsgemäß, mehrere Trägerelemente an einem Joystick für eine möglichst große Funktionsfläche anzuordnen, wobei mindestens ein Trägerelement gemäß der Erfindung ausgebildet ist und ein weiteres Trägerelement mit nur einem Leiterelement, insbesondere einem Heizelement ausgebildet ist. Die Zug- und Druckfestigkeit der Trägerfolie ist erfindungsgemäß derart, dass die daran angeordneten, im Wesentlichen unelastischen, Leiterelemente während der Montage nicht zerstört werden. Besonders vorteilhaft ist eine selbstklebende Ausbildung des Trägerelements, da zu seiner Anordnung am Griffbereich keine weiteren Hilfsmittel notwendig sind. Dies reduziert auf Grund der schnellen und vereinfachten Aufbringung sowohl Fertigungskosten als auch Materialkosten. Die Anordnung des Trägerelements an dem Griffbereich erfolgt erfindungsgemäß mittels eines Stempels oder manuell. Eine hohe Hitzebeständigkeit des Trägerelements ist besonders vorteilhaft, da dieses unmittelbar an dem Heizelement angeordnet ist.

In Ausgestaltung der Erfindung ist vorgesehen, dass das Trägerelement einen Steg aufweist, wobei an dem Steg zueinander beabstandete und voneinander weg weisende Rippen ausgebildet sind. In vorteilhafter Weise ist so dessen Biegung um mindestens zwei Achsen ermöglicht, ohne dabei das Risiko einer Falten- oder Rissbildung des Trägerelements zu erhöhen. Das Trägerelement ist demnach an die Kontur des Griffbereichs anpassbar. Erfindungsgemäß sind erste Biegungen entlang erster Biegekanten an dem Steg ausgebildet und zweite Biegungen entlang zweiter Biegekanten an den Rippen, wobei die ersten Biegekanten orthogonal zu den zweiten Biegekanten angeordnet sind.

Weiter ist eine im Wesentlichen mäanderförmige Ausbildung des mindestens einen Heizelements und eine dadurch erzeugte Abschirmung des mindestens einen berührungserfassenden Elements von elektromagnetischer Strahlung erfindungsgemäß. Das Heizelement ist als eine schmal verlaufende Leitung ausgebildet, welche einen vordefinierten Widerstand aufweist, sodass während eines steuerbaren Stromflusses durch das Heizelement elektrische Energie in Wärme umwandelbar ist. Auf Grund der gleichmäßigen Verteilung des Heizelements auf dem Trägerelement ist in besonders vorteilhafter Weise neben einer gleichmäßigen Wärmeabstrahlung eine Abschirmung des berührungserfassenden Elements von elektromagnetischer Strahlung ausgebildet. Demnach ist eine negative externe Beeinflussung der Funktionalität des berührungserfassenden Elements erfindungsgemäß minimiert.

In Ausgestaltung der Erfindung ist vorgesehen, dass die Leiterelemente jeweils mit einem Steuerelement verbunden sind, wobei das Steuerelement in Abhängigkeit der Signale des Temperatursensorelements und/oder des berührungserfassenden Elements und/oder des HMI Steuersignale an das Heizelement ausgebend ist. Mit Hilfe der gemessenen Werte des Temperatursensorelements ist eine individuell einstellbare Temperatur durch das Steuerelement erreichbar. In einer Ausführungsform wird die Regelung der Temperatur durch eine im Wesentlichen stufenlose Pulsweitenmodulation erreicht. In einer anderen Ausführungsform weist das Trägerelement mindestens zwei Heizelemente auf, welche zu- oder abschaltbar sind und demnach die Heizleistung des Trägerelements variieren. Eine von einem Nutzer gewünschte Temperatur ist über ein HMI (Human-Machine-Interface) konfigurierbar. Bei einer erfindungsgemäßen Ausführungsform wird eine Hand durch das berührungserfassende Element erkannt und eine Leitung zum Heizelement durch das Steuerelement geschlossen. Wird keine Hand erkannt, wird die Leitung zu dem Heizelement durch das Steuerelement unterbrochen. Eine von dem berührungserfassenden Element unabhängige Regelung des Heizelements ist ebenfalls erfindungsgemäß. Der Anschluss der Leiterelemente an das Steuerelement ist erfindungsgemäß über ZIF- oder LIF- Stecker oder crimpbare Steckkontakte realisiert, wobei crimpbare Steckkontakte in vorteilhafter Weise eine höhere Stromtragfähigkeit aufweisen.

In Ausgestaltung der Erfindung sind die mindestens drei Leiterelemente materialidentisch ausgebildet. Dies vereinfacht den Fertigungsprozess und reduziert die Kosten und die Fertigungsdauer, da ein gemeinsames Fertigungsverfahren anwendbar ist und die mindestens drei Leiterelemente in besonders vorteilhafter Weise in einem gemeinsamen Fertigungsschritt auf das Trägerelement aufbringbar sind.

In Weiterbildung der Erfindung ist vorgesehen, dass die Leiterelemente beschichtet sind, insbesondere mit einer Karbonschicht. Sofern der Widerstandswert des Heizelements nicht ausreichend sein sollte, um eine ausreichende Heizleistung zu erreichen, ist in besonders vorteilhafter Weise durch die Beschichtung eine Erhöhung des Leitungswiderstandes und damit eine Erhöhung der Heizleistung ausbildbar. Neben einer Karbonschicht sind andere, den Leitungswiderstand erhöhende, Beschichtungen ebenfalls erfindungsgemäß.

Die Erfindung wird nachfolgend anhand eines Ausführungsbeispiels mittels der Figuren näher erläutert, wobei
- **Fig. 1**: eine Schnittansicht eines Joysticks,
- **Fig. 2**: eine Innenseite einer Halbschale,
- **Fig. 3**: eine Seitenansicht zweier Trägerelemente,
- **Fig. 4**: eine Explosionsansicht des Trägerelements und der Leiterelemente und
- **Fig. 5**: eine grafische Darstellung der elektrischen Verbindungen zeigen.

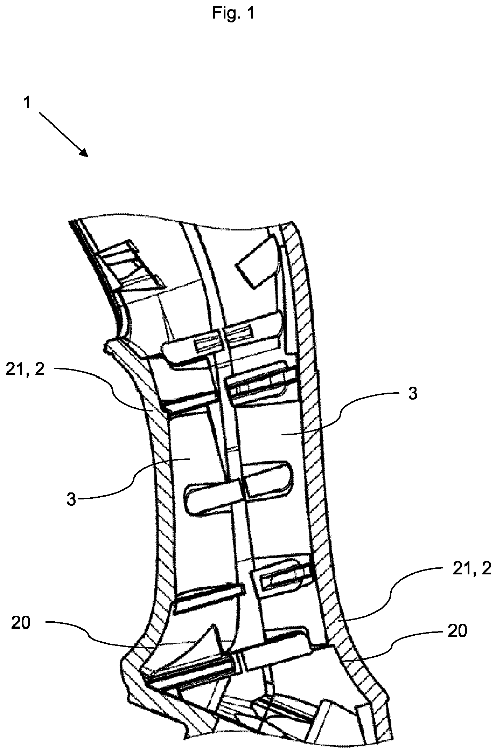

**Fig. 1** zeigt eine Schnittansicht eines Joysticks 1, wobei der Joystick 1 einen, aus zwei Halbschalen 21 bestehenden, Griffbereich 2 aufweist, an deren Innenflächen 20 jeweils ein Trägerelement 3 angeordnet ist. Das erste Trägerelement 3 ist dabei auf einer dem Nutzer zugewandten Seite und das zweite Trägerelement 3 auf einer dem Nutzer abgewandten Seite des Griffbereichs 2 angeordnet. Diese Anordnung ermöglicht die Erkennung und Beheizung einer Handinnenfläche des Nutzers sowie dessen auf der gegenüberliegenden Seite des Griffbereichs 2 anliegenden und in etwa auf die Handinnenfläche weisenden Fingerinnenflächen.

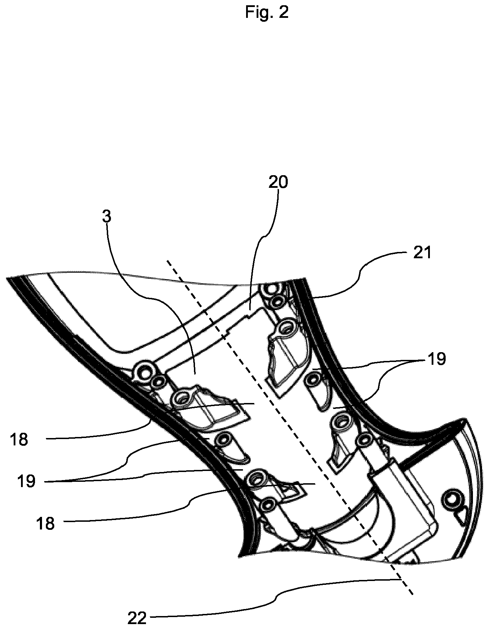

**Fig. 2** zeigt eine Innenseite einer Halbschale 21, wobei das Trägerelement 3 eine selbstklebende Trägerfolie ist, die direkt auf die Innenfläche 20 aufgeklebt ist. Das Trägerelement 3 weist einen Steg 18 mit zueinander beabstandeten und voneinander weg weisenden Rippen 19 auf. Die Rippen 19 weisen eine dreidimensionale Teilkreisform um eine Joystickachse 22 auf.

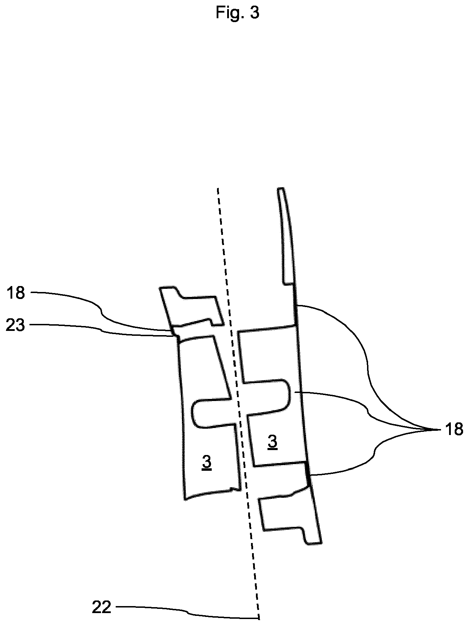

**Fig. 3** zeigt eine Seitenansicht zweier Trägerelemente 3, wobei deren Form an eine jeweilige Form der nicht dargestellten Halbschalen 21 abgepasst ist. Der Steg 18 des linken Trägerelements 3 weist eine Treppenform auf, wobei ein Brückenbereich 23 zur Reduktion und Erweiterung des Radius in Bezug auf die Joystickachse 22 ausgebildet ist. Erfindungsgemäß kann der Steg 18 auch mehrere Brückenbereiche 23 aufweisen und ist somit optimal an eine Form der nicht dargestellten Innenfläche 20 anpassbar. Demnach ist eine Anpassung des Trägerelements 3 an die wesentliche Form des Griffbereichs 2 ermöglicht, ohne das Trägerelement 3 zu beschädigen. Auch ein ungewolltes Auftreten von Falten auf dem Trägerelement 3 ist durch diese Ausbildung erfindungsgemäß minimiert.

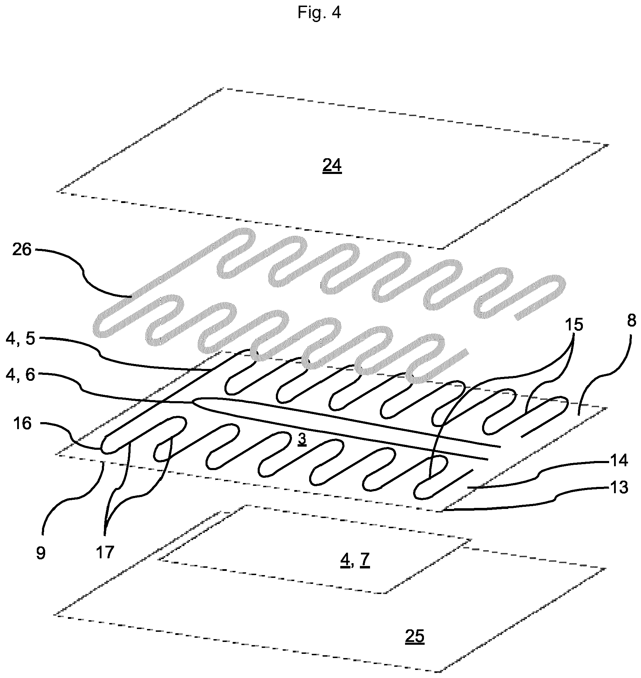

**Fig. 4** zeigt eine Explosionsansicht eines erfindungsgemäßen Trägerelements 3 und der Leiterelemente 4, wobei ein Temperatursensorelement 6 und ein Heizelement 5 auf einer ersten Seitenfläche 8 und ein berührungserfassendes Element 7 auf einer zweiten Seitenfläche 9 aufgedruckt sind. Die Leiterelemente 4 sind von einem, an einem Umfang des Trägerelements 3 ausgebildeten, Randbereich 14 beabstandet angeordnet, ausgenommen deren Anschlusspunkte 12 (nicht dargestellt). Die Leiterelemente weisen jeweils mindestens einen nicht dargestellten Anschlusspunkt 12 an einer kurzen Seitenkante 13 des Trägerelements 3 auf, wobei erfindungsgemäß das berührungserfassende Element 7 einen Anschlusspunkt 12, das

Heizelement 5 zwei Anschlusspunkte 12 und das Temperatursensorelement 6 vier Anschlusspunkte 12 aufweist. Die Anschlusspunkte 12 sind derart voneinander beabstandet, dass eine elektrische Verbindung zwischen den einzelnen Leiterelementen 4 ausgeschlossen ist. Das Heizelement 5 verläuft entlang zweier Stränge 15 jeweils mäanderförmig, wobei der Abstand zwischen dem Randbereich 14 und einer Krümmung 16 des Heizelements 5 und der Abstand zwischen zweier Schenkel 17 des Heizelements 5 im Wesentlichen gleich sind. Das Temperatursensorelement 6 ist im Wesentlichen u-förmig zwischen den zwei Strängen 15 mittig des Trägerelements 3 angeordnet. Das Heizelement 5 und das Temperatursensorelement 6 sind demnach beide auf der ersten Seitenfläche 8 anordenbar, ohne sich in ihrer Funktion zu beeinflussen. Da das berührungserfassende Element 7 zur zuverlässigen Detektion der Hand im Wesentlichen vollflächig ausgebildet ist, ist dieses separiert auf der zweiten Seitenfläche 9 angeordnet. Darüber hinaus ist das Temperatursensorelement 6 und das Heizelement 5 zwischen dem Trägerelement 3 und einem Korrosionsschutzelement 24 angeordnet, wobei zwischen Heizelement 5 und Korrosionsschutzelement 24 eine Beschichtung 26 eingebracht ist, welche ebenfalls mäanderförmig und entlang dem Verlauf des Heizelements 5 ausgebildet ist. Das berührungserfassende Element 7 ist zwischen dem Trägerelement und einem Klebeelement 25 angeordnet.

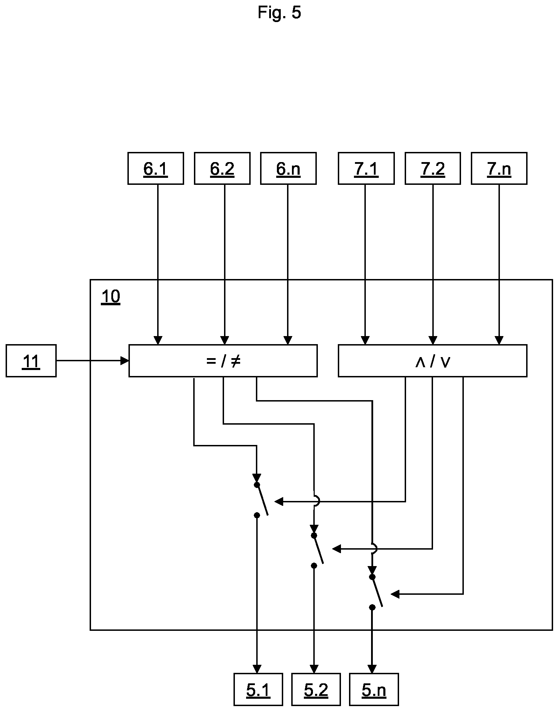

**Fig. 5** zeigt eine grafische Darstellung der elektrischen Verbindungen innerhalb des Joysticks 1, wobei die Messsignale der Temperatursensorelemente 6 und die Messsignale der berührungserfassenden Elemente 7 in das Steuerelement 10 geleitet sind. Darüber hinaus empfängt das Steuerelement 10 Signale von einem HMI 11. Innerhalb des Steuerelements 10 wird zum einen ein Abgleich der Istwerte der Temperatur aus den Messsignalen der Temperatursensorelemente 6 mit den Sollwerten, welche innerhalb des HMI 11 durch einen Nutzer individuell einstellbar sind, abgeglichen. Je nach Übereinstimmung beziehungsweise Abweichung der Istwerte von den Sollwerten werden entsprechende Steuersignale aus dem Steuerelement 10 zu den jeweiligen Heizelementen 5 geleitet. Zum anderen wird innerhalb des Steuerelements 10 anhand der Messsignale der berührungserfassenden Elemente 7 erkannt, ob eine Berührung einer Hand an dem Joystick 1 vorliegt. Je nach Logik des Steuerelements 10 bewirkt das Erfassen einer Hand von einem, mehreren oder allen berührungserfassenden Elementen 7 das Schließen der Signalleitung von dem Steuerelement 10 zu den Heizelementen 5. Sofern keine Erfassung einer Hand an dem Joystick 1 vorliegt, ist der Schalter geöffnet und die Heizelemente 5 sind nicht ansteuerbar. Über das HMI 11 sind der oder die Schalter auch unabhängig von den Temperatursensorelementen 6 schließbar.

### BEZUGSZEICHENLISTE

- 1: Joystick
- 2: Griffbereich
- 3: Trägerelement
- 4: Leiterelement
- 5: Heizelement
- 6: Temperatursensorelement
- 7: berührungserfassendes Element
- 8: erste Seitenfläche
- 9: zweite Seitenfläche
- 10: Steuerelement
- 11: HMI
- 12: Anschlusspunkt
- 13: kurze Seitenkante
- 14: Randbereich
- 15: Strang
- 16: Krümmung
- 17: Schenkel
- 18: Steg
- 19: Rippe
- 20: Innenfläche
- 21: Halbschale
- 22: Joystickachse
- 23: Brückenbereich
- 24: Korrosionsschutzelement
- 25: Klebeelement
- 26: Beschichtung

## Patentansprüche

1. Joystick (1) zur Bedienung von Nutzfahrzeugen, aufweisend einen Griffbereich (2), wobei der Griffbereich (2) eine stoffschlüssige und/oder formschlüssige Verbindung zu einem Trägerelement (3) aufweist, wobei an dem Trägerelement (3) mindestens drei Leiterelemente (4) angeordnet sind, wobei mindestens ein Leiterelement (4) als ein Heizelement (5), eines als ein Temperatursensorelement (6) und eines als ein berührungserfassendes Element (7) ausgebildet sind.

2. Joystick (1) nach Anspruch 1, **dadurch gekennzeichnet, dass** die Leiterelemente (4) mittels eines Druckverfahrens, insbesondere mittels Siebdruckes auf eine erste Seitenfläche (8) und/oder eine zweite Seitenfläche (9) des Trägerelements (3) aufgedruckt sind.

3. Joystick (1) nach Anspruch 1 oder 2, **dadurch**
**gekennzeichnet, dass** das Trägerelement (3) als Trägerfolie ausgebildet ist und/oder selbstklebend und/oder hitzebeständig ist.

4. Joystick (1) nach einem der vorhergehenden Ansprüche,
**dadurch gekennzeichnet, dass** das Trägerelement (3) einen Steg (18) aufweist, wobei an dem Steg (18) zueinander beabstandete und voneinander weg weisende Rippen (19) ausgebildet sind.

5. Joystick (1) nach einem der vorhergehenden Ansprüche,
**dadurch gekennzeichnet, dass** das mindestens eine Heizelement (5) im Wesentlichen mäanderförmig und als Abschirmung von elektromagnetischer Strahlung des mindestens einen berührungserfassenden Elements (7) ausgebildet ist.

6. Joystick (1) nach einem der vorhergehenden Ansprüche,
**dadurch gekennzeichnet, dass** die Leiterelemente (4) jeweils mit einem Steuerelement (10) verbunden sind, wobei das Steuerelement (10) in Abhängigkeit von erfassten Signalen des Temperatursensorelements (6) und/oder des berührungserfassenden Elements (7) und/oder des HMI (11) Steuersignale an das Heizelement (5) ausgebend ist.

7. Joystick (1) nach einem der vorhergehenden Ansprüche,
**dadurch gekennzeichnet, dass** die Leiterelemente (4) materialidentisch sind.

8. Joystick (1) nach einem der vorhergehenden Ansprüche,
**dadurch gekennzeichnet, dass** die Leiterelemente (4) beschichtet sind, insbesondere mit einer Karbonschicht.
